# EUROPEAN PATENT APPLICATION

(11) **EP 2 323 184 A1**
(43) Date of publication of application: **18.05.2011**
(21) Application number: 09175903.5
(22) Date of filing: 13.11.2009
(51) Int. Cl.: H01L 33/50, H01L 33/46

(54) **LED assembly**

(71) Applicant: Koninklijke Philips Electronics N.V., 5621 BA Eindhoven (NL); Philips Intellectual Property & Standards GmbH, 20099 Hamburg (DE)
(72) Inventor: The designation of the inventor has not yet been filed
(74) Representative: Volmer, Georg

(57) **Abstract**

The invention relates to a A LED assembly, comprising a LED die (10), a phosphor layer (12), and a filter layer (14), wherein said filter layer is developed in such a manner that light rays with a wavelength of about 400 nm to 500 nm are at least partially reflected depending on their emission angle to the normal on the filter layer (14) and wherein a reflection peak develops for angles > 50° normal to the filter layer starting at about 650 nm and moving down to about 500 nm at angle close to parallel to the filter layer.

## Description

### FIELD OF THE INVENTION

The invention relates to the field of light emission diode (LED) assemblies. Particularly the invention relates to enhanced emission phosphor-converting LED light assemblies (pcLED). Such assemblies are often employed to provide white light.

### BACKGROUND OF THE INVENTION

White light emitting LEDs generally comprise a blue emitting LED combined with a phosphor layer that is stimulated by the blue emission of the LED into emitting yellow light, green light and red light, the combination of the yellow, green, red and blue emissions providing a white light. For normal direction, vertical to the surface of the LED die or vertical to the surface of the phosphor layer with an emission angle of 0°, the path length in the phosphor layer of the light rays emitted by the blue emitting LED is equal to the thickness of the phosphor layer. For increasing emission angles the path length for blue light rays increases. Accordingly the fraction of absorbed blue light rays by the phosphor layer is lower for the light rays with an emission angle of 0° than for the light rays with an increasing emission angle. Since the converted light emitted by the phosphor layer always has a Lambertian over angle distribution, the white light emitted by the LED has a higher correlated colour temperature for normal emission with an emission angle of about 0°. Generally, the phosphor layer is a Y3A15O12:Ce3+ (YAG:Ce). In case of such a YAG:Ce phosphor layer emitted light becomes yellowish or greenish with increasing emission angle, perceived as yellow ring or green ring. To solve the yellow ring problem or the green ring problem it is known to increase the scattering power of the phosphor layer and/or to add a scattering layer on top of the phosphor layer. For both, the reduction of the yellow ring problem or the green ring problem results in a reduction of the LED efficiency, since scattering is accompanied by light reflection leading to light losses. In particular, scattering of the down-converted phosphor emission leads to reflection with accompanied reflection losses.

### SUMMARY OF THE INVENTION

It is an object of the invention to provide a light emission diode (LED) assembly to decrease the angle dependent emission of the LED assembly essentially without a reduction of the light emission efficiency.

This object is achieved by the features of claim 1. Preferred embodiments are given by the dependent claims.

The light emission diode (LED) assembly according to the invention comprises a LED die, a phosphor layer, and a filter layer, said filter layer is developed in such a manner that light rays with a wavelength of about 400 nm to 500 nm are at least partially reflected depending on their emission angle to the normal on the filter layer (14) and wherein a reflection peak develops for angles > 50° normal to the filter layer starting at about 650 nm and moving down to about 500 nm at angle close to parallel to the filter layer.

The LED die is preferably a blue emitting LED. The phosphor layer is preferably Y3A15012:Ce3+ (YAG:Ce). The filter layer is preferably a dichroic dielectric filter layer. This filter layer realises a partial reflection of light rays depending from the wavelength of the light rays and the emission angles to the normal of the filter layer of the light rays emitted by the LED die. For emission angles ≤50° to the normal of the filter layer partial reflections of the light rays with a wavelength of about 400 nm to 500 nm are provided. Light rays with a wavelength of about 400 nm to 500 nm are blue light rays emitted by the LED die. Additionally, for emission angles > 50° to the normal of the filter layer partial reflections of the light rays with a maximum reflectance at wavelength of about 500 nm to 650 nm formed as a reflection peak, are provided. Light rays with a wavelength of about 500 nm to 650 nm are green-blue light rays to red light rays emitted by the LED die and/or the phosphor layer. The reflection peak enables an increase of the color coordinate u' or Δu' and a decrease of the color coordinate v' or Δv'. This provides a more uniform over angle emission of the light emitted by the LES to be able to increase the light emission efficiency of the LED assembly. The partial reflections of the blue light rays emitted by the LED die and the blue-green to yellow part of the spectrum emitted by the phosphor layer, depending on their emission angle to the normal of the filter layer, realizes a uniform over angle emission without a major loss of efficiency of the light emitted by the LED. The normal on the filter layer is along the axis vertical to the plain surface of the filter layer.

For uniform white light emitted by the LED die the emitted intensity ratio of directly emitted light from the LED die and converted light from the phosphor layer has to be constant under all angles. Usually, light emitted by the LED and partially absorbed by the phosphor layer exhibits a forward peak form when compared with a Lambertian intensity distribution. However, the yellow light emitted by the phosphor layer usually provides almost always a perfect Lambertian or cosine distribution. Thus, the ratio of blue light to yellow light decreases with increasing emission angles. This effect is often perceived as the yellow ring problem. By reflection of a certain amount of the blue light for small emission angles < 50° it is possible to adapt the blue light intensity emitted by the LED to the intensity distribution emitted by the phosphor layer so that the blue light and the yellow light have the same ratio over emission angles from 0° to 50°. In order to fit the intensity distributions for emission angle > 50° a certain amount of the green-blue light to the red light is reflected, with the maximum reflectance rapidly shifting from red to the green-blue part of the spectrum. Thus, a superposition of all light rays, especially of green light, red light, yellow light and blue light over all emission angles is obtained so that uniform white light is emitted by the LED assembly over all emission angles without a yellow ring problem or a green ring problem.

According to a preferred embodiment of the invention said filter layer comprises a thickness of > 1 µm, preferably of > 1.5 µm. By using a filter layer with a thickness of > 1 µm, preferably of > 1.5 µm, it is possible to adjust the filter layer to reflection characteristics. Thus, it is especially possible to achieve that a reflection peak develops for angles > 50 °normal to the filter layer starting at about 640 nm and moving down to about 530 nm at angle close to parallel to the filter layer.

According to a further preferred embodiment of the invention said filter layer is deposited on a surface with a roughness of 30 nm < Ra < 300 nm, preferably of 80 nm < Ra < 150 nm. By using such a roughned surface it is possible to diminish the effect of the filter layer and to mix and homogenize the filter layer effectiveness between all emission angles. This may especially cause a favorable filter characteristics for all emission angles and a robust filter deposition process, tolerant to thickness variations in the different filter layers.

Preferably, the phosphor layer is arranged on top of said LED die and said filter layer is arranged on top of the phosphor layer, wherein the rough surface is a surface of the phosphor layer adjoining the filter layer. By depositing the filter layer on a rough surface with a roughness of about 30 nm < Ra < 300 nm, preferably of about 80 nm < Ra < 150 nm, according to the invention it is possible to partially reflect light rays with a wavelength of about 500 nm to 650 nm, preferably of about 500 nm to 600 nm, for emission angles of about > 50° to the normal of the filter layer with a high effectiveness for the wanted adaptation of the intensity ratios of light emitted by the LED die and light emitted by the phosphor layer.

The filter layer comprises preferably a dielectric layer coating of alternating low and high refractive index materials. The alternating low and high refractive index materials may be chosen in such a manner that a well directed reflection of the blue light emitted by the LED die can be achieved for emission angles ≤50° to the normal of the filter layer and a well directed reflection of the green-blue light to the red light emitted by the LED die can be achieved for emission angles > 50° to the normal of the filter layer.

The materials of the dielectric coating layer are preferably transparent for wavelength between 400 nm and 800 nm with a refractive index of the high refractive index materials in the range of 1.6 to 3 and with a refractive index of the low refractive index materials in the range of 1.2 to 1.8. The absorption coefficient of the index materials is < 0.00001 for wavelength > 480 nm and < 0.003 for wavelength > 400 nm. Nb₂O₅ (niobium oxide) is preferably used as high refractive index material and SiO̅₂ (silicon oxide) is preferably used as low refractive index material.

Preferably, the filter layer comprises fifteen layers of the high refractive index material and fifteen layers of the low refractive index material. By using a high number of layers of the filter layer the filter layer is very robust against thickness variations during deposition of the filter layer and variations of the surface rough of the substrate. The layers may be applied by thin film deposition techniques like chemical vapour deposition or sputtering.

Moreover, the layers of high refractive index materials preferably vary in thickness from 10 nm to about 200 nm and the layers of low refractive index materials preferably vary in thickness from about 45 nm to about 200 nm.

The phosphor layer may comprise a Lumiramic plate and/or phosphor powder embedded in a transparent matrix material. The Lumiramic plate is a polycrystalline ceramic plate of a phosphor material. The Lumiramic plate may be made from a Ce(III) doped garnet material ((M^{I}_{1-x-y}M^{II}xM^{III}y)₃(A¹_{1-z}M^{IV}z)₅O₁₂ with M^{I} = (Y, Lu); M^{II} = (Gd, La, Yb); M^{III} = (Tb, Pr, Ce, Er, Nd, Eu) und M^{IV} = (Gd, Sc) with 0 ≤ x ≤ 1; 0 ≤ y ≤ 0,1 und 0 ≤ z ≤ 1) or from Ce(III) and/or Eu(II) doped nitridosilicate (*M*₂Si₅N₈) and oxonitridosilicate materials (*M*Si₂0₂N₂) (M = alkaline earth). It is very advantageously to combine such a Lumiramic plate with a blue light emitting LED die to produce white light in the range of 5000 - 7000 K correlated color temperature (CCT). For generation of light with CCT < 5000 K usually two phosphor materials are used, either as a combination of two Lumiramic plates or a combination of a Lumiramic plate with a phosphor powder material embedded in a transparent matrix. Scattering and light extraction means of the Lumiramic ceramic color converter plates enable production of reliable and efficient white pcLEDs. Measurement of the optical properties of the Lumiramic plates or Lumiramic plates with a phosphor powder material before the final LED assembly allows pick and place packaging with exact targeting of the desired white color point of the LED. By using a Lumiramic plate said Lumiramic plate may function as a substrate for the filter layer, wherein the Lumiramic plate may provide the rough surface for depositing the filter layer.

Further, according to a preferred embodiment of the invention, the Lumiarmic plate comprises a thickness of about 50 µm to 300 µm, preferably of about 100 µm to 200 µm.

Moreover, according to a preferred embodiment of the invention, the phosphor layer comprises a thickness of about 20 µm to 400 µm, preferably of about 50 µm to 200 µm.

### BRIEF DESCRIPTION OF THE DRAWINGS

These and other aspects of the invention will be apparent from and elucidated with reference to the embodiments described hereinafter.

In the drawings:
FIG. 1 is a schematic view of an embodiment of a LED assembly according to the invention;
FIG. 2 is a is graph showing dichroic filter transmission curves at different emission angles;
FIG. 3 is a graph of color point variations for WW pcLEDs as a function of different emission angles;
FIG. 4 is a transmission spectra of a dichroic filter layer deposited on an optcially plane substrate;
FIG. 5 is a graph of an emission spectra of a WW pcLED with a CCT of 3300 K for emission angles of 0° to 90°;
FIG. 6 is a graph of color point variations of a WW pcLED without and with a dichroic filter layer deposited on an optically plane Lumiramic surface;
FIG. 7 is a graph of color points of a WW pcLED with and without a dichroic filter layer deposited on a Lumiramic substrate;
FIG. 8 is a graph of color point variations of a WW pcLED with a dichroic filter layer and without a dichroic filter layer;
FIG. 9 is a graph of an emission spectra of a cool white pcLED at different emission angles form 0° to 90°;
Fig. 10 is a first graph of a color point variations of an emission angle for CW pcLEDs with a dichroic filter layer; and
Fig. 11 is a second graph of a color point variations of an emission angle for CW pcLEDs with a dichroic filter layer.

### DETAILED DESCRIPTION OF EMBODIMENTS

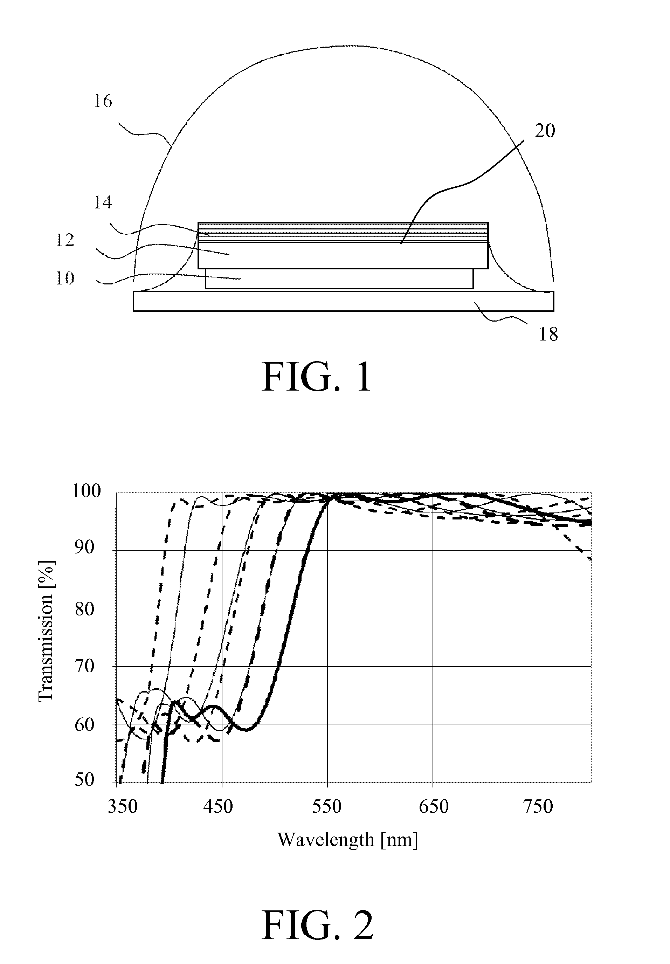

FIG. 1 shows an embodiment of a LED assembly according to the invention with a LED die 10, a phosphor layer 12 and a filter layer 14. The LED die 10, the phosphor layer 12 and the filter 14 are preferably covered by a lens 16 that may be optically coupled to the underlying layers. The LED die 10 emitting blue light with a wavelength of about 400 nm to 500 nm is positioned at the bottom 18 of the LED assembly. On the top of the LED die 10 the phosphor layer 12 is positioned. The phosphor layer 12 preferably emits green-blue light to red light with a wavelength of about 500 nm to 750 nm. The phosphor layer 12 may comprise a Lumiramic plate and/or a phosphor powder embedded in a transparent matrix material. The thickness of the phosphor layer 12 is about 100 µm to 400 µm On the top of the phosphor layer 12 the filter layer 14 is positioned, wherein the phosphor layer 12 comprises a rough surface 20 with a roughness of about 30nm < Ra < 300 nm, preferably of about 80 nm < Ra < 150 nm, on which the filter layer 14 is deposited. The filter layer 12 comprises a thickness of > 1 µm, preferably of > 1.5 µm which is formed by a dielectric layer coating of alternating low and high reflective index materials, like Nb₂0₅ and SiO₂.

FIG. 2 is a graph showing different dichroic filter transmission curves of a filter layer 14 deposited on a Lumiramic plate surface of the phosphor layer 12 at emission angles (from right to left) of 0°, 26°, 40° and 66° to the normal of the filter layer 14. The Lumiramic plate surface is optically polished comprising a roughness of about < 3 nm. The transmission curves are shown for two filter layers with different thickness. A filter layer with a large thickness is shown by the full lines and a filter layer with a smaller thickness is shown by the dashed lines. In FIG. 2 it can be seen that the filter transmission edge shifts to the blue spectral range for larger thickness of the filter layers, wherein the larger thickness of the filter layer may be a proportional increase of layer thickness for all layers. Thus, the position of the filter edge directly impacts the over-angle emission of a pcLED.

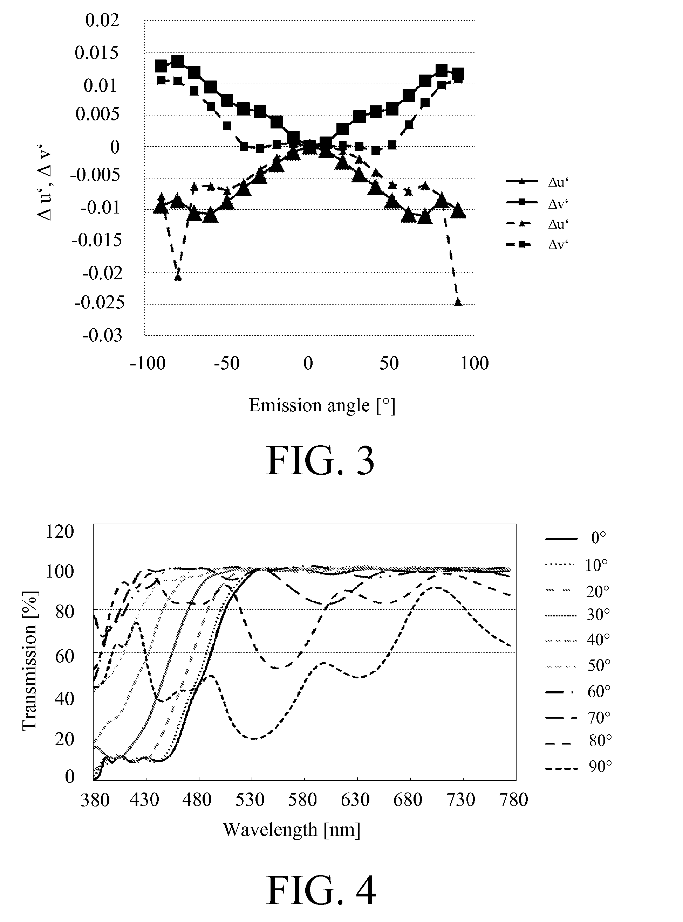

To show the problem of known LEDs FIG. 3 shows a graph of color point variations, i. e. the difference to color point at normal emission (CIE 1976 UCS) with a Δu' as a color coordinate and a Δv' as a color coordinate for warm white LEDs as a function of emission angle with a filter layer of large thickness (full lines) and a filter layer of a smaller thickness (dashed lines). There it can be seen that for larger emission angles u' or Δu' decreases which leads to the green ring problem and v' or Δv' is increasing. With the inventive LED assembly it is possible to overcome this problem in that u' or Δu' is increased for larger emission angles and v' or Δv' is decreased for larger emission angles to reach a more uniform color for all emission angles.

FIG. 4 shows transmission spectra of a dichroic filter layer 14 on an optcially plane substrate with a roughness of Ra < 10 nm as a function of wavelength for different transmission angles shown on the right side of FIG. 4. The filter layer 14 is designed in such a way that a narrow reflection peak appears for angles > 50°. This so-called "dip" starts at a wavelength of about 650 nm at an emision angle of around 60° and shifts with larger emission angles rapidly to below 550 nm at around 90°. Here "dip" means an indent of the transmission curves with lowest transmission at said wavelength, while the transmission curves may develop more than one indentation in the wavelength range between 450 nm and 780 nm. The filter layer 14 as shown in this graph has a layer construction shown in the following TABLE 1, wherein the total filter layer thickness is 1.675 µm:

**TABLE 1**

| Layer | Material | Thickness [nm] |
|---|---|---|
| Substrate | YAG_Lumiramic | |
| 1 | SiO₂ | 49.81 |
| 2 | Nb₂O₅ | 15.22 |
| 3 | SiO₂ | 89.2 |
| 4 | Nb₂O₅ | 16.32 |
| 5 | SiO₂ | 79.14 |
| 6 | Nb₂O₅ | 20.78 |
| 7 | SiO₂ | 66.61 |
| 8 | Nb₂O₅ | 22.55 |
| 9 | SiO₂ | 65.03 |
| 10 | Nb₂O₅ | 23.32 |
| 11 | SiO₂ | 65.69 |
| 12 | Nb₁Os | 18.9 |
| 13 | SiO₂ | 81.22 |
| 14 | Nb₂O₅ | 13.95 |
| 15 | SiO₂ | 105.62 |
| 16 | Nb₂O₅ | 13.56 |
| 17 | SiO₂ | 92.85 |
| 18 | Nb₂O₅ | 24.83 |
| 19 | SiO₂ | 73.59 |
| 20 | Nb₂O₅ | 36.14 |
| 21 | SiO₂ | 62.09 |
| 22 | Nb₂O₅ | 35.67 |
| 23 | SiO₂ | 90.29 |
| 24 | Nb₂O₅ | 16.05 |
| 25 | SiO₂ | 161.65 |
| 26 | Nb₂O₅ | 19.28 |
| 27 | SiO₂ | 65.59 |
| 28 | Nb₂O₅ | 162.24 |
| 29 | SiO₂ | 72.25 |
| 30 | Nb₂O₅ | 15.19 |
| Exit medium | Silicone | |

The thickness of the filter layer 14 plays an important role for the filter action on the LED assembly. Thus, the filter layer 14 according to the invention comprises a thickness, especially a total thickness, of about > 1 µm. more preferred of about > 1.5 µm.

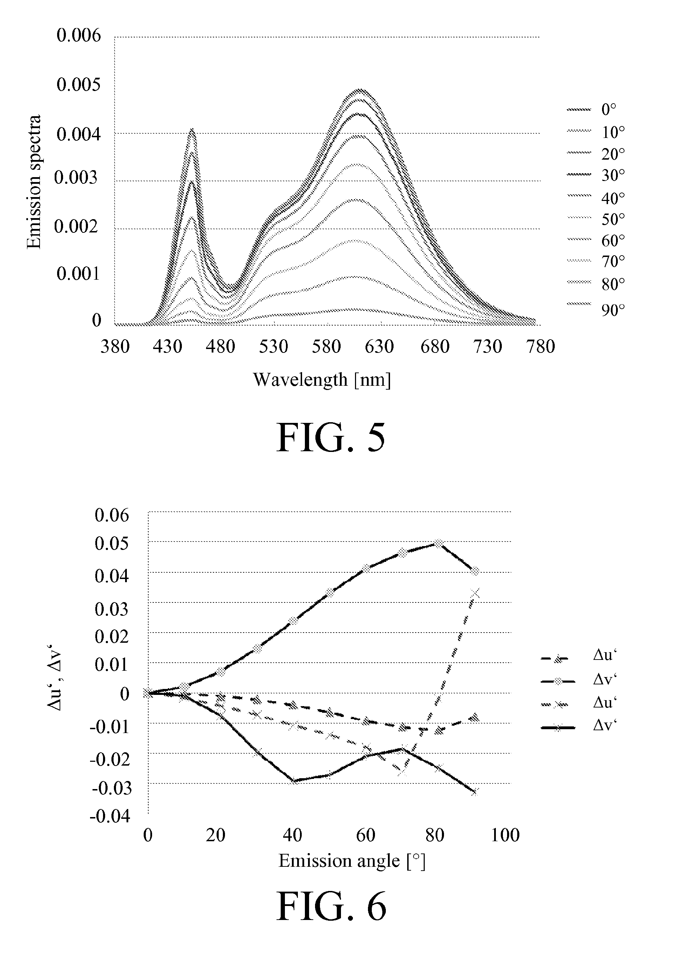

FIG. 5 shows a graph of emission spectra of a warm white pcLED (WW pcLED) with a Correlated Color Temperature (CCT) of 3300 K for emission angles of 0° to 90°. In this embodiment a 452 nm peak blue emitting LED die is covered with a red nitride phosphor layer and a Lumiramic plate of Y3A15012:Ce(0.4%) of 110 µm thickness and a silicone lens is glued on top of the Lumiramic plate. The phosphor layer comprises a thickness of 30 µm and a phosphor powder embedded in a silicone matrix.

The color point variation of the WW pcLED shown in FIG. 5 is depicted in FIG. 6 without a dichroic filter layer (connected circles for Δv' and dashed line connected triangles for Δu') and with a dichroic filter layer (star and cross) deposited on an optically plane Lumiramic surface. The dichroic filter layer acoording to this embodiment shown in Fig. 6 shows the desired effect to increase the color coordinate u' or Δu' with the designed "dip" in transmission, which occurs for emission angles > 70°. But by this embodiment it is still possible that a discoloration of the emitted light may occur with increasing emission angles. In order to intermix filter transmission curves of different emission angles the dirchroic filter layer may be additionally deposited on a rough surface instead of an optically plane surface.

A roughness of about 30 nm < Ra < 300 nm, preferably of about 80 nm < Ra < 150 nm, of the surface 20 on which the filter layer 14 is deposited may lead to an especially preferred filter layer action on LED emission. LED assemblies comprising a filter layer 14 deposited on a rough surface 20 leads to a desired effect of mixing extremely large angle emission into emission under smaller angles. As a result the filter layer "dip" at large angles is also active for emission under smaller angles.

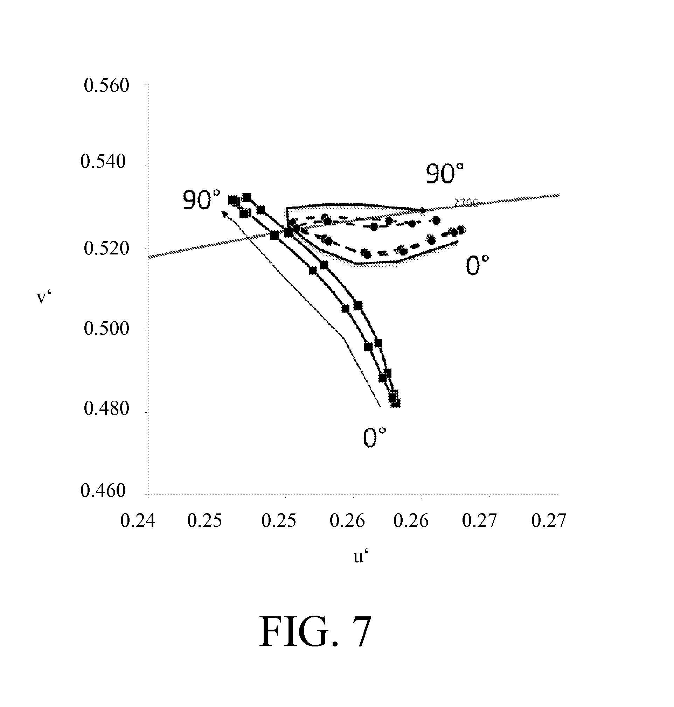

FIG. 7 shows a color points of WW pcLED with a dichroic filter layer 14 (dashed lines) and without a dichroic filter layer (full lines) deposited on a Lumiramic substrate. As shown in FIG. 7, the color point variation is moved towards the Planckian, which eliminates any visible discoloration to a large extend, when using a filter layer with a thickness > 1 µm which is deposited on a rough surface. In FIG. 7 the filter layer is deposited on a rough surface 20 with a roughness of about Ra = 120 nm.

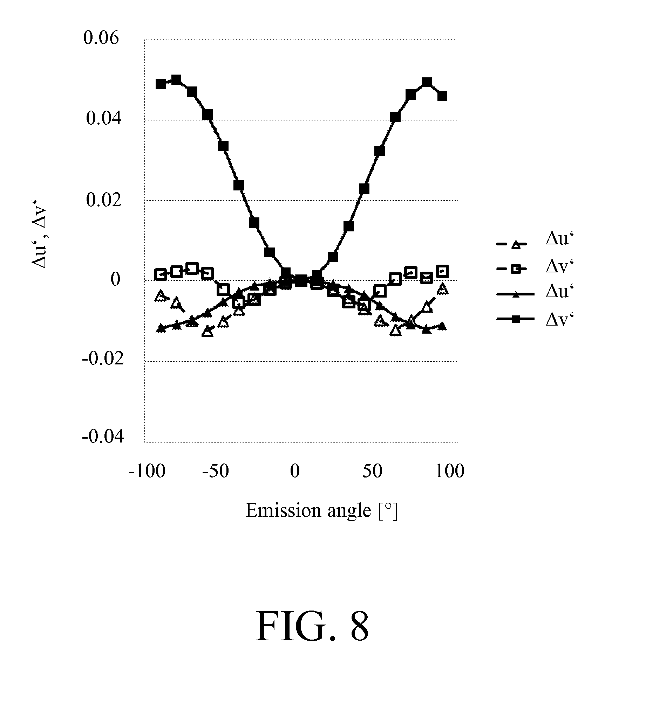

FIG. 8 shows a color point variation of a WW pcLED with a dichroic filter layer 14 (shown as open symbols) and without a dichroic filter layer (shown as full symbols). The filter layer 14 of FIG. 8 is deposited on a rough surfcae with a roughness of about 120 nm. As shown in FIG. 8, the color point variation with increasing emission angle is getting very small and Δu' increases for emission angles > 50° by using a LED assembly according to the invention.

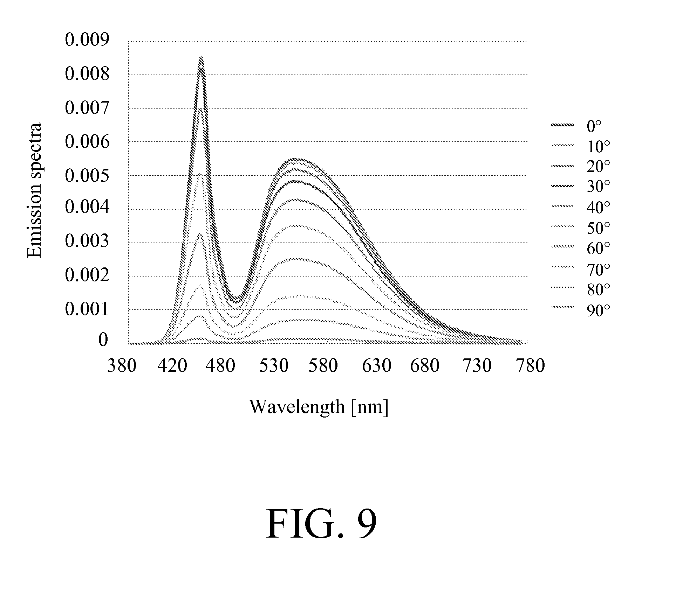

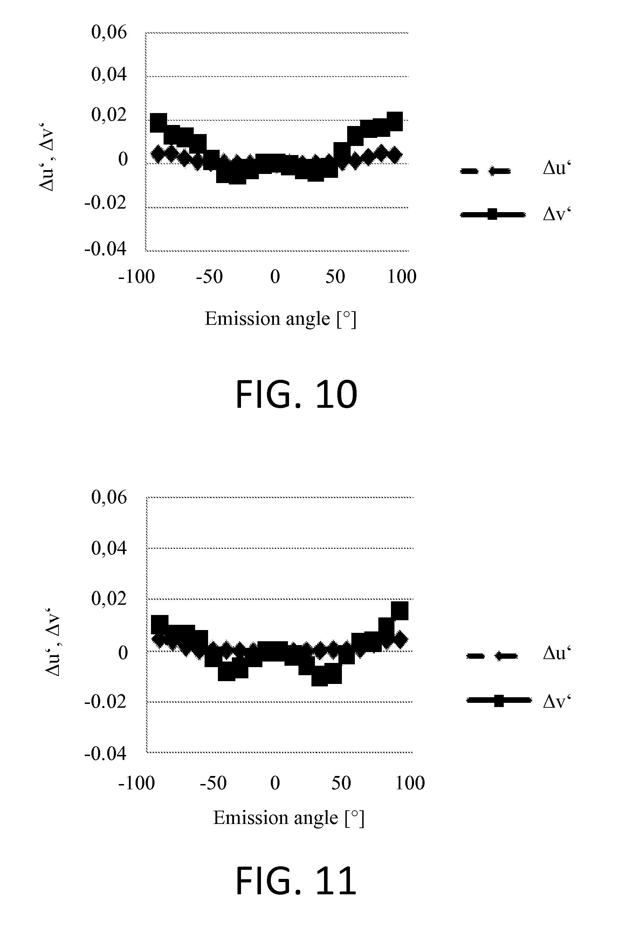

The same inventive dichroic filter layer 14 may be used without a red phosphor layer to create a cool white pcLED (CW pcLED). FIG. 9 shows emission spectra of a cool white pcLED at different emission angles form 0° to 90° using a blue LED with a yellow emitting YAG:Ce Lumiramic plate. Thus, the same filter layer 14 used for WW pcLED may also be used for cool white pc LED with a CCT > 5000 K. Fig. 10 shows a color point variation of an emission angle for CW pcLEDs with the inventive dichroic filter layer 14 on a rough surface at a LED peak wavelength of 452 nm. Fig. 11 shows a color point variation of an emission angle for CW pcLEDs with the inventive dichroic filter layer 14 on a rough surface at a LED peak wavelength of 442 nm.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

## Claims

1. A LED assembly, comprising
a LED die (10),
a phosphor layer (12), and
a filter layer (14),
wherein said filter layer is developed in such a manner that light rays with a wavelength of about 400 nm to 500 nm are at least partially reflected depending on their emission angle to the normal on the filter layer (14) and
wherein a reflection peak develops for angles > 50° normal to the filter layer starting at about 650 nm and moving down to about 500nmat angle close to parallel to the filter layer.

2. A LED assembly according to claim 1, wherein said filter layer (14) comprises a thickness of > 1 µm, preferably of > 1.5 µm.

3. A LED assembly according to claim 1, wherein said filter layer (14) is deposited on a surface (20) with a roughness of about 30 nm < Ra < 300 nm, preferably of about 80 nm < Ra < 150 nm.

4. A LED assembly according to claim 1, wherein said phosphor layer (12) is arranged on top of said LED die (10) and said filter layer (14) is arranged on top of said phosphor layer (12), wherein said rough surface (20) is a surface of the phosphor layer (12) adjoining said filter layer (14).

5. A LED assembly according to claim 1, wherein said filter layer (14) comprises a dielectric layer coating of alternating low and high refractive index materials.

6. A LED assembly according to claim 5, wherein said materials of dielectric coating layer are transparent for wavelength between 400 nm to 800 nm with a refractive index of said high refractive index materials in the range of 1.6 to 3 and said low refractive index material in the range of 1.2 to 1.8.

7. A LED assembly according to claim 5, wherein fifteen layers of said high refractive index material and fifteen layers of said low refractive index material are provided.

8. A LED assembly according to claim 5, wherein said layers of said high refractive index materials vary in thickness from 10 nm to about 200 nm and said layers of low refractive index materials vary in thickness from about 45 nm to about 200 nm.

9. A LED assembly according to claim 1, wherein said phosphor layer (12) comprises a Lumiramic plate and/or a phosphor powder embedded in a transparent matrix material.

10. A LED assembly according to claim 1, wherein said phosphor layer (12) comprises a thickness of about 20 µm to 400 µm, preferably of about 50 µm to 200 µm
